# EUROPEAN PATENT APPLICATION

(11) **EP 3 179 509 A1**
(43) Date of publication of application: **14.06.2017**
(21) Application number: 15003502.0
(22) Date of filing: 08.12.2015
(51) Int. Cl.: H01L 23/495, H01L 21/56

(54) **METHOD FOR MANUFACTURING A SEMICONDUCTOR PACKAGE**

(71) Applicant: Sensirion AG, 8712 Stäfa (CH)
(72) Inventor: Hunziker, Werner, 8712 Stäfa (CH)
(74) Representative: Toleti, Martin

(57) **Abstract**

A method for manufacturing a semiconductor package, comprising the step of providing an electrically conducting leadframe (2), the leadframe (2) comprising a die pad (21), a set of contact pads (22), a support lead (24) connected to the contact pads (22) of the set, and an area (AR) of reduced thickness (T2) in each contact pad (22) of the set extending across a full width (W) of the respective contact pad (22). A semiconductor chip (3) is mounted on the die pad. The leadframe (2) is arranged in a mold (4), the mold (4) comprising one or more protrusions (411) reaching into the areas (AR) of reduced thickness (T2). A mold compound is applied into the mold (4) for generating an arrangement comprising at least a partial encapsulation (1) of the semiconductor chip (3) with the areas (AR) of reduced thickness (T2) remaining free from the mold compound by means of the protrusions (411) in the mold (4). The arrangement is separated from the support lead (24) in the area (AR) of reduced thickness (T2) of each contact pad (22) of the set.

## Description

### Field of the Invention

The present invention relates to a method for manufacturing a semiconductor package, and to a semiconductor package.

### Technical Background

Semiconductor chips are mostly packaged by some encapsulation. Such package including the encapsulation often is arranged and electrically connected to a carrier, such as a printed circuit board or other carrier. While contact pads often are exposed at a bottom surface of the semiconductor chip, optical inspection means are desired to be applied for monitoring an integrity of each electrical contact between such contact pad and a contact pad of the carrier, which electrical contact may be achieved by a contact material such as solder. In some instances, contact pads of the semiconductor package are exposed to the side in a plane with a side wall of the encapsulation. Solder can be applied into the right angle between the exposed side surface of the contact pad and the carrier. However, this type of contact often does not sufficiently wet to the exposed side surface, and optical inspection may show insufficient reliability.

### Disclosure of the Invention

A method for manufacturing a semiconductor package is provided comprising the step of providing an electrically conducting leadframe. The leadframe comprises at least a die pad, a set of contact pads, and a support lead connected to the contact pads of the set. An area of reduced thickness is arranged in each contact pad of the set, and preferably extends from each contact pad of the set into the support lead, and extends across a full width of the respective contact pad. A semiconductor chip is mounted on the die pad. The leadframe including the semiconductor chip is arranged in a mold. The mold comprises one or more protrusions reaching into the areas of reduced thickness. A mold compound is applied into the mold for generating an arrangement comprising at least a partial encapsulation of the semiconductor chip with the area of reduced thickness remaining free from the mold compound by means of the protrusions in the mold. The arrangement is separated from the support lead in the area of reduced thickness of each contact pad.

The leadframe is an electrically conducting leadframe which is understood as an electrically conducting structure of leads and / or pads made out of metal, for example by punching or etching a metal sheet. A die pad is a portion of the leadframe offering a footprint sufficient for attaching a semiconductor chip to. The contact pads of the set are connected to a common support lead. Preferably, the support lead has a longitudinal extension orthogonal to a longitudinal extension of the contact pads. Typically, these contact pads are arranged in a row facing an edge of the die pad, and, in the final semiconductor package are separated from the support lead. Each contact pad may in the final semiconductor package serve for electrically contacting the semiconductor package to the outside. In the leadframe, a contact pad may solely be connected to the support lead, or may also be connected to the die pad in case of accepting the potential of the die pad. In the resulting semiconductor package, a bottom surface of the non-recessed portion of the contact pad preferably is entirely exposed from the encapsulation.

In a preferred embodiment, portions of the leadframe have a standard thickness which is the thickness of a metal sheet the leadframe is made from. However, portions or areas of the contact pads are reduced in thickness compared to the standard thickness. Such area may extend from each contact pad into the associate support lead across the full width of the contact pad. Hence, a first portion of each contact pad which preferably contains the end facing or terminating in the die pad remains at the standard thickness while a second portion which contains the end terminating in the support lead is of the reduced thickness. The area of reduced thickness extends across the width of the contact pad such that there are no lateral rims of standard thickness in this area. Generally, the support lead preferably has a longitudinal extension orthogonal to a longitudinal extension of the contact pads. Preferably, a length of the area of reduced thickness - orthogonal to its width - is less than a quarter of its overall length L.

A standard thickness of the support lead may be reduced only at the locations where the contact pads terminate in the support lead. Or, the support lead may completely be reduced from its standard thickness at least between the two outmost contact pads, or even extending beyond the two outmost contact pads.

Preferably, the die pad has a rectangular shape each with four edges, wherein the set of contact pads is arranged facing a first edge of the die pad. Preferably, another set of contact pads is provided which contact pads face a second edge of the die pad opposite the first edge. These contact pads are connected to another common support lead and each shows an area of reduced thickness, too. Further sets of contact pads may be arranged facing the other two edges of the die pad, too, each set being connected to a dedicated support lead. The rectangular die pad may also have a sloped corner, and still be considered as rectangle having four edges.

Hence, Dual Flat No Leads (DFN) or Quad Flat No Leads (QFN) packages may be manufactured.

Instead of a QFN package, one or more leads may extend from the die pad at these other two edges not facing contact pads to support leads for holding the die pad.

In a preferred embodiment, multiple semiconductor packages are manufactured in the same processing steps thereby making use of a leadframe onto which multiple semiconductor chips can be placed. Such leadframe preferably comprises a die pad per semiconductor chip. Multiple die pads may be provided per semiconductor package in case other chips are to be arranged in the package, such as an ASIC, etc. In another embodiment, the multiple semiconductor chips can be arranged on the same die pad.

In the embodiment of a common leadframe for multiple semiconductor chips, it is preferred, that a common support lead is provided for two sets of contact pads belonging to adjacent die pads, and hence to adjacent semiconductor packages to be built. It is preferred, that the contact pads of the two sets terminate in the support lead at the same longitudinal position of the support lead. Hence, in one embodiment, the areas of reduced thickness of contact pads of the sets belonging to different semiconductor packages meet and may contribute to a single area of reduced thickness in the common support lead. Hence, a common area of reduced thickness is generated per contact pad pair of a common support lead. Accordingly, multiple protrusions may be provided in the mold for reaching into the various areas of reduced thickness. In case the entire support lead is designed of reduced thickness, a single common area of reduced thickness is generated for the support lead and the contact pads of different sets terminating in the support lead. Here, a single protrusion of corresponding shape may be provided in the mold for supporting this entire area. In a different embodiment, the protrusion may even extend outside this area and e.g. evoke a recess in the encapsulation.

On each die pad of a leadframe, a semiconductor chip is mounted. Preferably, electrical connections are established between each semiconductor chip and corresponding contact pads, such as by means of bond wires. In addition, each semiconductor chip is molded by means of a molding compound which preferably is an epoxy with filler particles which filler particles e.g. may be glass, and specifically Si02. For doing so, the leadframe is arranged in a mold. Specifically, the mold comprises a bottom mold onto which the leadframe is set with its bottom surface which bottom surface includes the areas of reduced thickness. The bottom mold comprises one or more protrusions reaching into the areas of reduced thickness. Hence, the bottom mold is designed to adapt to the bottom surface profile of the leadframe, at least in the areas or reduced thickness. The one or more protrusions may be integrated with the bottom mold, or attached thereto, possibly in a releasable way. A top mold may, together with the bottom mold contribute to the mold between which top and bottom mold the leadframe including the semiconductor chips are arranged in. The top mold may comprise a projection, again integrated or attached thereto, per semiconductor chip in case an access is required to the semiconductor chip. This may be the case if the semiconductor chip is a sensor chip comprising a sensing element which requires access to the environment for appropriate sensing.

The mold compound is applied into the mold for generating an arrangement comprising at least a partial encapsulation of the semiconductor chip. Owed to the one or more protrusions in the bottom mold, the areas of reduced thickness in the contact pads and possibly the support lead remain free from the mold compound. In a preferred embodiment, the one or more recessed areas in the leadframe may be protected from mechanical impact during molding and at the same time may be sealed by preferably an elastic film arranged at least between the areas of reduced thickness and the protrusion/s in the bottom mold. The film may e.g. be a PET film or a PTFE film. Preferably, the film extends between the entire bottom mold and the entire leadframe. The film may initially be attached either to the leadframe or to the bottom mold. After molding the film may be removed again. The same means may be applied to the top mold in case an access opening shall be manufactured in the encapsulation granting access to a sensing element of the semiconductor chip. Again, preferably an elastic film may be arranged at least between each sensing element and each projection in the top mold. In the present application, the molding compound may include any plastic material or dry resist that may in any form be molded, such as injection-molded, transfer-molded, or otherwise be molded.

The resulting arrangement, be it for one or multiple semiconductor packages is separated from the support lead by severing each contact pad in the area of reduced thickness. Preferably, this is achieved in a common severing step by means of a linear severing tool cutting all contact pads to the same length. The separating step results in electrically isolating the contact pads of the set from each other.

The separating step in one embodiment includes sawing the arrangement. The sawing may be executed along the longitudinal extension of the support lead by means of a blade. In a preferred embodiment, a width of the blade exceeds a width of the support lead resulting in a complete removal of the support lead and in a cutting of each contact pad in the area of reduced thickness. In case contact pads of two sets belong to adjacent semiconductor packages, a single cutting operation may separate each of the resulting semiconductor packages from the support lead and from each other. Preferably, and in case of manufacturing multiple semiconductor packages on a common leadframe, the sawing step is applied in case a mold is used that allows for a common encapsulation for all semiconductor chips on the leadframe. In this case, the mold compound is allowed to deposit on the one or more support leads and on all the contact pads. The sawing then can be applied from the top which includes sawing through the encapsulation first and through the leadframe after, or from the back which includes sawing through the leadframe first and through the encapsulation after.

In a different embodiment, the separation step may include punching the leadframe with a punch instead of sawing with a blade. In this case, it is preferred that the encapsulation does not extend onto the one or more support leads but terminates e.g. prior to the areas of recessed thickness. The mold is designed accordingly. The punching then can be applied from the top or from the back of the leadframe and does not require punching through any mold compound.

As a result of any of the above embodiments, each contact pad of the set exposes a step which step is accessible from a side wall of the semiconductor package. Hence, the recesses in the contact pads provide space for retracting contact material such as solder applied for electrically connecting the contact pads to e.g. metallizations of a carrier such as a printed circuit board. This arrangement is preferred in that each recess becomes wetted by the contact material. Preferably, the contact material is placed on various metallizations of a carrier, and the semiconductor package is placed with each contact pad, and preferably with an exposed bottom surface of the non-recessed portion of each contact pad onto each spot of the contact material. By means of placing and pressing the semiconductor material onto / against the carrier, the contact material wets the recess and the exposed surfaces of the recess. On the other hand, the resulting semiconductor package arranged on a carrier, and specifically the, and preferably each electrical connection established by the contact material between the contact pad and the carrier can be optically inspected in particular from the top of the semiconductor package or at least from the side. The inspection can in particular be performed automatically, or in a different embodiment by a person. In addition, the contact pads offer sufficient surface to be wetted by the contact material in contrast of providing only dimples in the contact pads. In particular in case of small scale contact pads, it is important to generate a sufficient wetting surface. In addition, a side surface of the portion with the recessed area - which is the surface that becomes exposed by the cutting or punching step - is small which is preferred over larger side surface designs when it comes to sawing. The smaller the side surface, the less burrs occur during sawing the leadframe which burrs may also cover areas to be wetted by the contact material. This side surface of each contact pad is aligned in a common plane with a side wall of the encapsulation. The portion of the contact pad with the standard thickness has a side surface that is exposed, too, but which is recessed with respect to the above side surface. A bottom of the portion of the contact pad with the standard thickness is exposed. In one embodiment, not only the contact pads of the set show the recess in form of a step, but the encapsulation between two adjacent contact pads shows this step, too.

In a preferred embodiment of the present invention, the leadframe is plated after having structured the die pad and the contact pads, and after having manufactured the areas of reduced thickness in the contact pads, i.e. specifically prior to the molding and the separating step. In case the leadframe is made from a material susceptible to corrosion, such as copper, it is preferred that the leadframe is plated with a material less susceptible to corrosion, such as a noble material, for example Pt, Au or Ag. By preventing corrosion of the leadframe, and in particular of the contact pads of the leadframe at the exposed areas used for contacting to the outside, the quality and lasting of such contact is increased since in case of corrosion, the contact material may no longer wet the corroded contact pad.

However, in the present case of initial plating of the leadframe prior to molding, the final semiconductor package only has plated portions that are exposed from the package, except for side surfaces produced by severing. On the other hand, the surfaces of the recess or step in the contact pad and the bottom surface of its non-recessed portion are plated, which are the surfaces critical for establishing the electrical contact, which are the surfaces supposed to contact the solder, for example. If, instead, these recesses / steps would be achieved by sawing after molding the critical surfaces would remain non-plated even if the leadframe were plated at the very beginning.

Hence, a post-molding plating of exposed surfaces of the contact pads and possibly the die pad can be avoided by means of the above embodiment, which post-molding plating in particular is not desired when the semiconductor chip is a sensor chip which supports a sensing element and has an access opening for the sensing element. Such sensing element may then not be protected during plating or needs to be protected during plating, as otherwise it would be exposed to chemical substances in case of chemical and /or galvanic plating. Therefore, the suggested method results in a semiconductor package that already shows plated exposed portions of the contact pads and does not require any post-molding plating not feasible for certain applications of the package, e.g. for sensing applications.

Accordingly, a semiconductor package, is introduced comprising a semiconductor chip arranged on a die pad, contact pads for electrically contacting the semiconductor package, each contact pad comprising an area of reduced thickness extending across a full width of the corresponding contact pad, and an encapsulation at least partially enclosing the semiconductor chip. Each area of reduced thickness is exposed. Preferably, the semiconductor chip comprises a sensing element, the encapsulation comprises an access opening for providing access to the sensing element, and each contact pad is plated in the area of reduced thickness.

Other advantageous embodiments are listed in the dependent claims as well as in the description below.

### Brief Description of the Drawings

Embodiments of the present invention, aspects and advantages will become apparent from the following detailed description thereof. Such description makes reference to the annexed drawings, wherein the figures show:
Figs. 1 to 4 diagrams illustrating steps of a method for manufacturing a semiconductor package according to an embodiment of the present invention;
Fig. 5 a side cut of a contact pad of a semiconductor package according to an embodiment of the present invention;
Figs. 6 to 9 diagrams illustrating steps of a method for manufacturing multiple semiconductor packages according to an embodiment of the present invention;
Fig. 10 a diagram illustrating an alternative step to the step illustrated in Fig. 8.

### Detailed Description of the Drawings

All embodiments shown in the Figures may be applicable to the manufacturing of QFN as well as DFN packages.

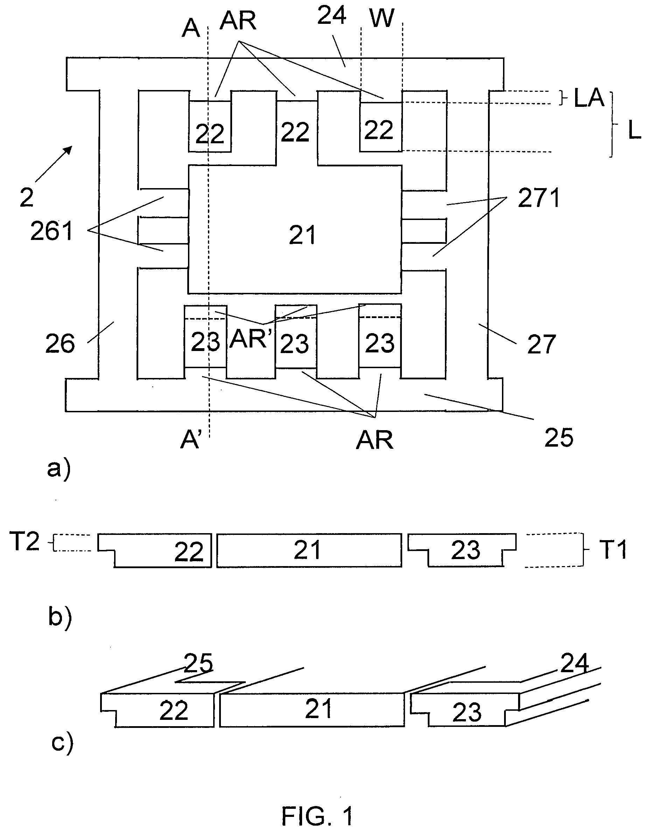

Figures 1 to 4 illustrate steps of a method for manufacturing a semiconductor package according to an embodiment of the present invention.

Figure 1 illustrates a leadframe as used in a method according to an embodiment of the present invention. In diagram 1a), the leadframe is illustrated in a bottom view, in diagram 1b) in a side cut, and in diagram 1c) in a partial perspective view.

A leadframe typically is a grid like structure made from an electrically conducting material. The individual interconnected leads may be etched or punched from a thin sheet of metal. It is assumed, that the present leadframe 2 already is prepared into a shape as shown in diagram 1a) for the purpose of manufacturing a semiconductor package thereon. The present leadframe 2 contains, for example, horizontal support leads 24 and 25 and vertical support leads 26 and 27. The leadframe 2 further comprises a die pad 21 serving as a platform to mount a semiconductor chip on. The die pad 21 is connected to the vertical support leads 26, 27 by means of leads 261 and 271. The horizontal support leads 24 and 25 contain finger like extensions, which represent contact pads 22 and 23 of the future semiconductor package.

The contact pads 22 constitute a set with each contact pad 22 of this set facing the die pad 21 from a first side. The contact pads 23 constitute another set with each contact pad 23 of this other set facing the die pad 21 from a second side opposite the first side.

The side cut shown in diagram 1b) is a cut along line A-A' of diagram 1a). It becomes apparent from diagram 1b) that the leadframe 2 shows two different thicknesses T1 and T2. While thickness T1 is a standard thickness, e.g. of the metal sheet the leadframe 2 is manufactured from, thickness T2 is a reduced thickness when compared to the standard thickness T1. Accordingly each contact pad 22 and 23 of the set and the other set has an area AR of reduced thickness T2 which area AR extends from each contact pad 22, 23 into the corresponding support lead 24 or 25 respectively. Hence, the horizontal lines in the contact pads 22 and 23 in the bottom view of diagram 1a) represent steps from the standard thickness T1 towards the reduced thickness T2. In one embodiment, and introduced only at contact pads 23, but applicable to all or none of the contact pads, each contact pad may additionally have another area AR' of reduced thickness T2 facing the die pad 21. In the present embodiment, each support lead 24 and 25 entirely shows a reduced thickness T2 which can also be derived from the perspective view of a part of the leadframe 2 in diagram 1c). The die pad 21 is assumed to be of the standard thickness T1. The leads 261 and 271 between the support leads 26 and 27 and the die pad 21 are of the reduced thickness T2. The support leads 26 and 27 connecting to the die pad 21 are of the standard or of the reduced thickness T2.

It is understood, that the overall number of contact pads 22, 23, the allocation of contact pads 22, 23 with respect to the die pad 21, and the geometry of the die pad 21 may vary. The support leads 24 and 25 connecting to the contact pads 22 and 23 not necessarily need to be entirely of reduced thickness. For example, the areas of the support leads 24 and 25 between two neighboring contact pads 22 or 23 may be of the standard thickness.

Each contact pad 22, 23 has a width W. The reduced thickness T2 is applied all across the width W of the contact pad 22, 23. An extension of the area AR of reduced thickness T2 along the length of each contact pad may depend on the needs of exposure of the contact pad in the final semiconductor package. Preferably, a length LA of the area of reduced thickness - orthogonal to its width W - is less than a quarter of its overall length L. In such embodiment, a good wetting and sufficient contact material outside the package is achieved for enabling optical inspection.

The areas AR of reduced thickness T2 may be manufactured, e.g. by etching, either after having structured the die pad 2 and the contact pads 22, 23, or together with. The leadframe 2 - after being structured and partly reduced in thickness preferably is coated by an anticorrosion coating, such as a plating enclosing the leadframe 2.

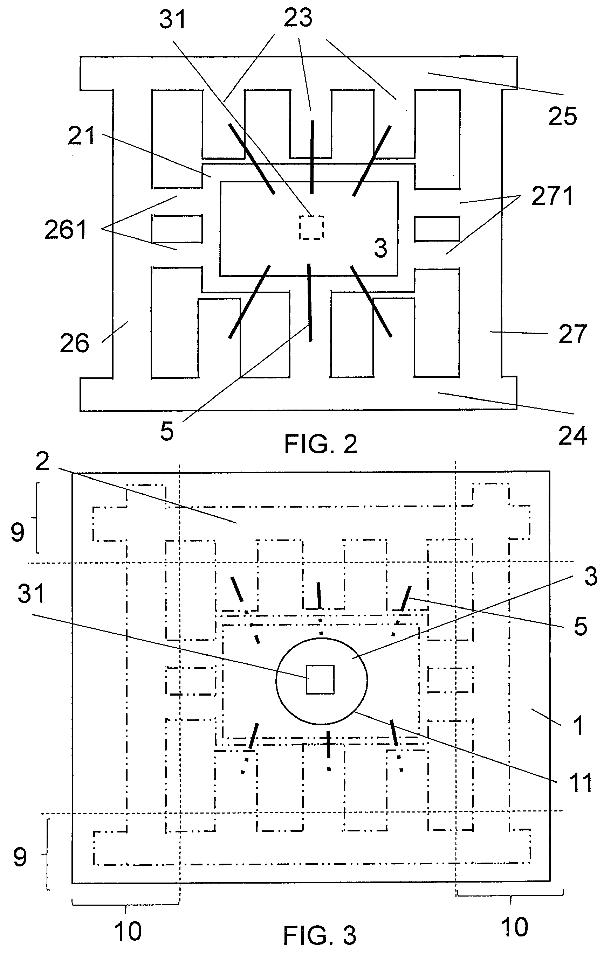

In a following step, as is shown in Figure 2 in a top view on the leadframe 2, a semiconductor chip 3 is mounted on the die pad 21. The semiconductor chip 3 may in one embodiment be electrically connected to the contact pads 22 and 23 by means of bond wires 5.

The semiconductor chip 3 preferably is a silicon chip, and in a preferred embodiment is a sensor chip containing a sensing element indicated as 31, and preferably contains integrated circuitry for processing signals supplied from the sensing element 31. The semiconductor chip 3 may be prepared from a wafer and the circuitry if any may be integrated on wafer-level. The sensor elements 31 may be integrated on wafer-level, too, or be applied onto a surface of the semiconductor chip later on. The semiconductor chip 3 may also be further prepared e.g. by manufacturing a recess in the backside of the semiconductor chip, e.g. on wafer-level.

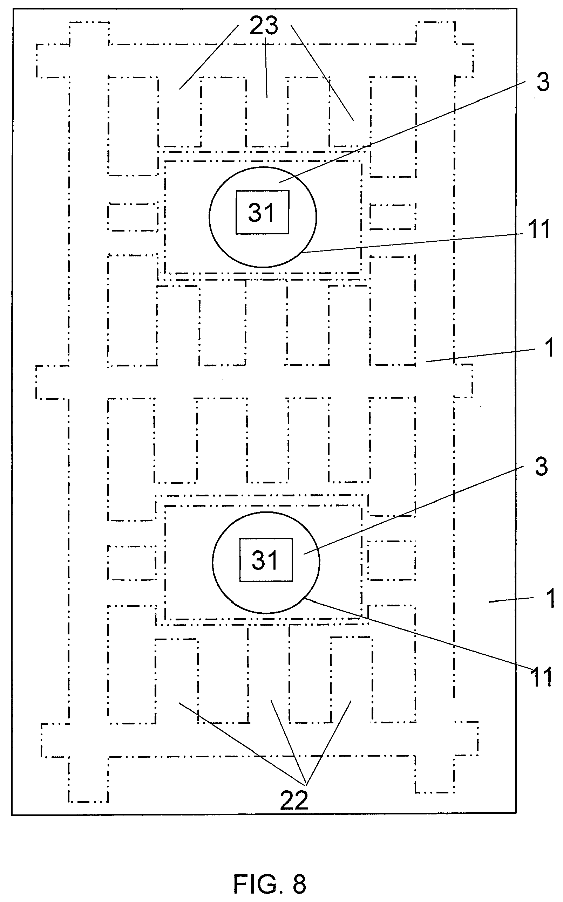

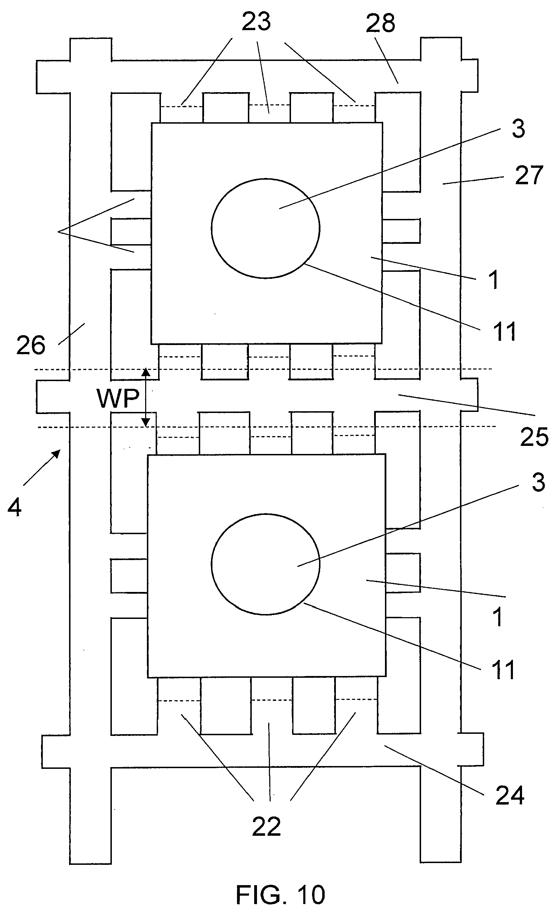

In a further step, the arrangement containing the leadframe 2 and the semiconductor chip 3 is arranged in a mold and a molding compound is applied into the mold. As to the shape of the resulting encapsulation, it is referred to the below description of Figures 8 and 10. As a result, the arrangement now comprises an encapsulation 1 fully or partly encapsulating the semiconductor chip 3. According to the top view of Figure 3, the semiconductor chip 3 is partly encapsulated, leaving an opening 11 in the encapsulation 1 for granting access to the sensing element 31, if any. The leadframe 2 and the semiconductor chip 3 covered by the mold compound are illustrated in a phantom view. The dashed lines in Figure 3 indicate sawing streets 9 and 10 by which the arrangement is separated from the support leads in a next step resulting in a semiconductor package shown in a perspective view in diagram 4a), and in a bottom view in diagram 4b).

As can be derived from the bottom view in diagram 4b), a bottom surface of the contact pads 22 and 23 is exposed, wherein each contact pad 22, 23 has two levels. The inner area facing the die pad 21 preferably is on the same level as the die pad 21, while the outer area which is the area of reduced thickness is on a second level lower than the level of the die pad 21. Hence, each contact pad 22, 23 shows a step. However, in the present embodiment, not only the contact pads 22, 23 show a step, but also the encapsulation 1. This can also be derived from the perspective view of diagram 4a).

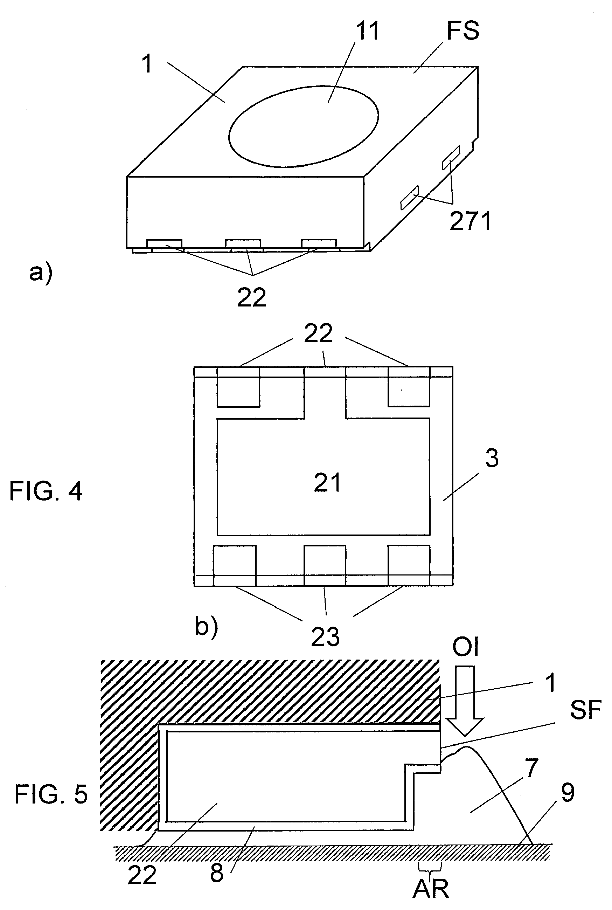

Figure 5 refers to an enlarged side cut of a contact pad 22 of a semiconductor package according to an embodiment of the present invention. In this example, the leadframe the present contact pad 22 is a part of was plated prior to being molded. The plating is indicated by reference 8. The semiconductor package is assumed to be arranged on a carrier 9, such as a printed circuit board. It can be derived from Figure 5, that all surfaces of the contact pad 22 that are exposed - i.e. the surfaces that are not covered by the encapsulation 1, show a plating 8 which is preferred for wetting with a contact material 7 such as solder, except for a side surface SF of the area AR of reduced thickness, which is the surface at which the contact pad 22 was separated from the corresponding support lead. In case of proper wetting of the contact material 7 on the area AR of reduced thickness - and in contrast to the poorly wetted side surface SF -, the shape of the contact material 7 outside the package allows for a reliable optical inspection of the contact from the top as is indicated by arrow OI. On the other hand, the surfaces in the recess wetted by the contact material 7 are maximized ensuring an enhanced electrical and mechanical contact, too.

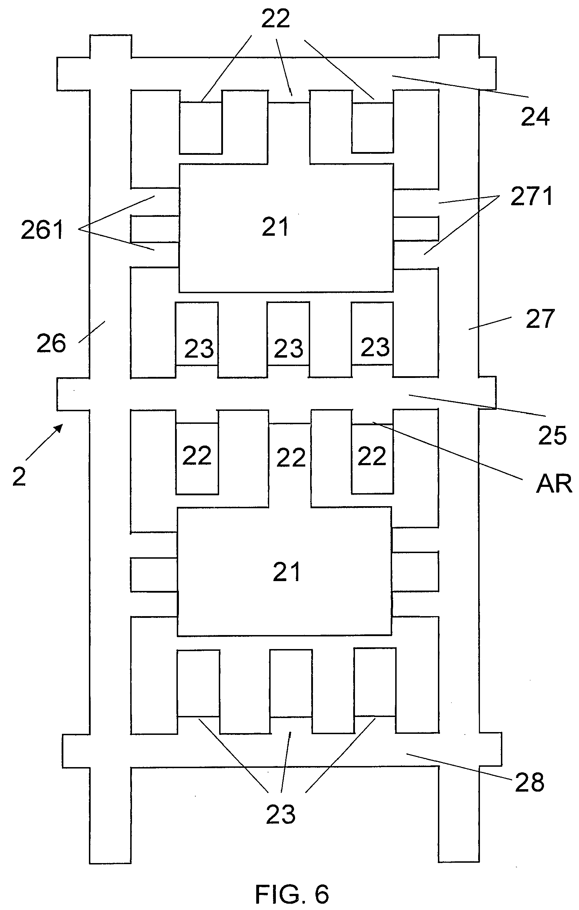

Figures 6 to 9 illustrate steps of a method for manufacturing multiple semiconductor packages according to an embodiment of the present invention. Here, multiple semiconductor packages are manufactured by common manufacturing steps on a common leadframe 2. Although in the present example, the leadframe 2 comprises only two platforms for building a semiconductor packages on, it is understood, that in real manufacturing the leadframe 2 may contain many more platforms, e.g. for building tens or hundreds of semiconductor packages on.

Accordingly, the leadframe 2 of Figure 6, which again illustrates a bottom view thereon, basically is a duplication of the leadframe of Figure 1, except that the support lead 25 now serves as support lead for the contact pads 23 of the upper package to be built, and at the same time as support lead for the contact pads 22 of the lower package to be built. The support lead for the contact pads 23 of the lower package is referred to as 28. The support leads 26 and 27 are common support leads for both die pads 21 and may also serve as common support leads for further die pads arranged next to the support leads 26 and 27 on the other sides, if any. Corresponding to Figure 2 but not shown in the present Figures, semiconductor chips 3 are attached to both die pads 21 at their front side, and each semiconductor chip 3 is electrically connected to the associate contact pads 22 and 23. In a next step, this arrangement is inserted into a mold.

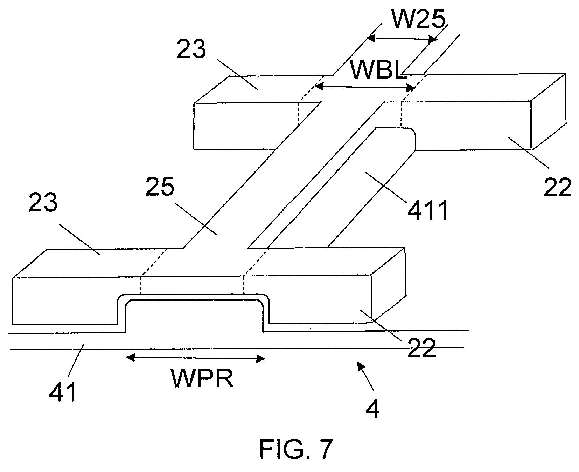

Figure 7 illustrates the molding process by showing only a portion of the leadframe of Figure 6 applied to a bottom mold 41 of a mold 4. The portion of the leadframe 2 includes the support lead 25, two contact pads 22 and two contact pads 23 connected to the support lead 25, the contact pads 22 and 23 belonging to different adjacent packages to be built. As can be derived from Figure 7, a portion of each contact pad 22, 23 is recessed reaching into the support lead 25. The entire support lead 25 is recessed, such that a common recessed area is provided. Now the leadframe 2 is arranged into the mold 4, only the bottom mold 41 of which is shown. The bottom mold 41 comprises a protrusion 411 which is little smaller than the recessed portion such that this protrusion 411 supports the recessed portion of the leadframe 2. In the present example, and owed to the shape of the recessed portion in the leadframe 2, the protrusion 411 has the shape of a ridge. It is preferred, that a film not shown is arranged between the leadframe and the bottom mold 41, which basically covers the entire bottom mold 41. This film is arranged for protecting the leadframe during molding.

In a step illustrated in Figure 8 in a top view, a molding compound is applied on top of the present arrangement such that the molding compound encapsulates the corresponding semiconductor chips 3 except for an opening 11 which provides access to a portion of the semiconductor chip 3 e.g. containing a sensing element. The encapsulation 1 provides mechanical stability and protects the semiconductor chips 3. The encapsulation 1 is made from insulating material, such as epoxy containing filler particles such as glass, specifically Si02. The mold is filled, and the molding compound 1 may harden into the solid encapsulation 1. As can be seen from Figure 8, the encapsulation 1 extends over the leadframe 2 as a common continuous encapsulation over all semiconductor chips 3 except for the openings 11. The leadframe and the semiconductor chips 3 covered by the encapsulation 1 are illustrated in a phantom view.

In a different embodiment as shown in Figure 10, individual encapsulations 1 per package are built which encapsulations 1 are disconnected from each other. For manufacturing these blocks, the mold 4 has a different shape than for producing the encapsulation 1 of Figure 8.

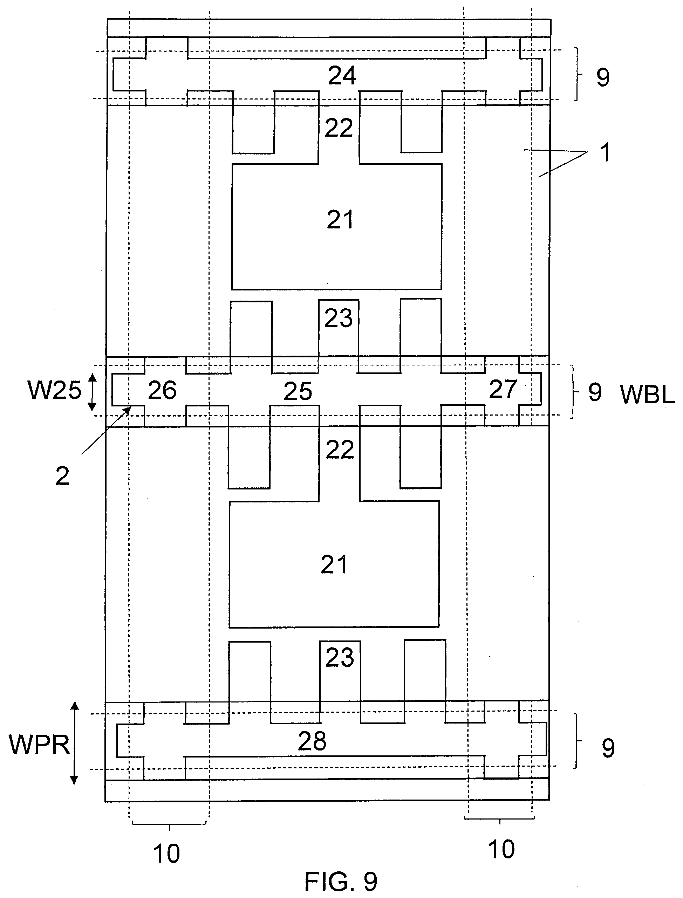

For separating the packages from each other, and specifically for separating the packages from the arrangement shown in Figure 8, it is preferred to sever these supply leads 24 to 28 either from the back side of the present arrangement or from its front side. In Figure 9, a bottom view of the arrangement of Figure 8 is illustrated. Sawing streets 9 are indicated along which the support leads 24, 25 and 28 of the contact pads 22, 23 are cut. A blade in such sawing step may e.g. have a width WBL, which width WBL exceeds a width W25 of the support lead 25 but which width WBL is less than a distance WPR between steps introducing the areas of reduced thickness facing each other. The support leads 26 and 27 connecting the die pads 21 remain intact, i.e. it is only horizontally diced. In a next step, the remaining arrangement may be diced along sawing streets 10, i.e. along the vertical support leads 26 and 27.

Instead, the arrangement according to Figure 10 comprises separate enclosures 1 per package during molding. As a result, the support leads between adjacent packages are exposed, such as support lead 25. In such embodiment, the separation of the packages may preferably be achieved by punching the leadframe 2 between the encapsulations 1 of two adjacent packages. In this example, the punch may have a width WP and remove the support lead 25 and the portions of the contact pads 22 and 23 between the encapsulations 1 which portions all contribute to the area of the leadframe 2 with a reduced thickness. The step in the contact pads between the standard thickness and the reduced thickness is indicated as dashed lines, given that these steps are only visible in a bottom view of the leadframe.

While above there are shown and described embodiments of the invention, it is to be understood that the invention is not limited thereto but may be otherwise variously embodied and practised within the scope of the following claims.

## Claims

1. Method for manufacturing a semiconductor package, comprising the steps of
- providing an electrically conducting leadframe (2), the leadframe (2) comprising
- a die pad (21),
- a set of contact pads (22),
- a support lead (24) connected to the contact pads (22) of the set,
- an area (AR) of reduced thickness (T2) in each contact pad (22) of the set extending across a full width (W) of the respective contact pad (22),
- mounting a semiconductor chip (3) on the die pad,
- arranging the leadframe (2) in a mold (4), the mold (4) comprising one or more protrusions (411) reaching into the areas (AR) of reduced thickness (T2),
- applying a mold compound into the mold (4) for generating an arrangement comprising at least a partial encapsulation (1) of the semiconductor chip (3) with the areas (AR) of reduced thickness (T2) remaining free from the mold compound by means of the protrusions (411) in the mold (4),
- separating the arrangement from the support lead (24) in the area (AR) of reduced thickness (T2) of each contact pad (22) of the set.

2. Method according to claim 1,
wherein the die pad (21) and the contact pads (22, 23) of the leadframe (2) are manufactured from a metal sheet of a standard thickness (T1) by removing material between the die pad (21) and the contact pads (22, 23) throughout the standard thickness (T1) of the metal sheet,
wherein the areas (AR) of reduced thickness (T2) are generated by partially removing material from the leadframe (2) or the metal sheet resulting in a thickness (T2) reduced with respect to the standard thickness (T1) of the metal sheet,
wherein each contact pad (22) includes both a portion having the standard thickness (T1) and a portion having the reduced thickness (T2), and
preferably wherein a length (LA) of each area of reduced thickness orthogonal to its width (W) is less than a quarter of its overall length (L).

3. Method according to claim 1 or claim 2, wherein the leadframe (2) is plated prior to the molding step and prior to the separating step.

4. Method according to any one of the preceding claims,
wherein the area (AR) of reduced thickness (T2) in each contact pad (22) of the set extends into the support lead (24), and
preferably wherein the support lead (24) is of reduced thickness (T2) at least between the two outmost contact pads (22) resulting in a continuous area of reduced thickness (T2) across the support lead (24) and each of the contact pads (22).

5. Method according to any one of the previous claims,
wherein separating the arrangement from the support lead (24) includes sawing along the support lead (24) by means of a blade of a width (WBL) exceeding a width (W25) of the support lead (24) resulting in a removal of the support lead (24) and in a cutting of each contact pad (22) in the area (AR) of reduced thickness (T2) thereby exposing a step in each contact pad (22).

6. Method according to any one of the previous claims,
wherein the mold (4) is designed to allow the mold compound to deposit on a top surface of the support lead (24) and a complete top surface of each contact pad (22) of the set, and
wherein the arrangement is separated through the encapsulation (1) and the contact pads (22) of the set.

7. Method according to any one of the previous claims 1 to 5,
wherein the mold (4) is designed to prevent the mold compound to deposit on the support lead (24), and
wherein the arrangement is separated by punching.

8. Method according to any one of the preceding claims,
wherein the semiconductor chip (3) is a sensor chip,
wherein the mold (4) comprises a projection, wherein the leadframe (2) is arranged in the mold (4) with the projection facing a sensing element provided in or on the sensor chip, or facing an area on the sensor chip reserved for allocating a sensor element, and
wherein a partial encapsulation (1) with an access opening (11) for the sensor chip is generated by applying the mold compound, and
preferably wherein the mold (4) comprises a bottom mold (41) comprising the one or more protrusions (411) and a top mold comprising the projection, wherein the bottom mold (41) faces the top mold, and wherein the leadframe (2) containing the mounted sensor chip is arranged between the bottom mold (41) and the top mold, and
wherein a first sealing film (SF1) is applied between the bottom mold (41) and the leadframe (2) and a second sealing film (SF2) is applied between the top mold and the sensor chip.

9. Method according to any of the preceding claims,
wherein the semiconductor package resulting from separating the arrangement from the support lead (25) is placed on a carrier,
wherein contact material (7) is applied to at least one, and preferably all, of the contact pads (22, 23) to generate an electrical connection from the semiconductor chip (3) to the carrier,
wherein each electrical connection is optically inspected by automated optical inspection,
and preferably wherein each electrical connection is optically inspected by the automated optical inspection applied from a top of the semiconductor package.

10. Method according to any one of the preceding claims,
wherein the die pad (21) has a rectangular shape with four edges,
wherein the contact pads (22) of the set are arranged facing a first of the four edges of the die pad (21),
wherein contact pads (23) of another set are arranged facing a second edge of the four edges opposite the first edge,
wherein the contact pads (23) of the other set are connected to another support lead (25),
wherein each contact pad (23) of the other set comprises an area (AR) of reduced thickness (T2) extending across a full width (W23) of the respective contact pad (23),
wherein the one or more protrusions (411) of the mold (4) reach into the areas (AR) of reduced thickness (T2) of the contact pads (23) of the other set,
wherein the areas (AR) of reduced thickness (T2) of the contact pads (23) of the other set remain free from the mold compound after molding, and
wherein the arrangement is separated from the other support lead (25) by severing each contact pad (23) of the other set in the area (AR) of reduced thickness (T2).

11. Method according to any one of the preceding claims, for manufacturing multiple semiconductor packages,
wherein the leadframe (2) comprises
- multiple die pads (21),
- at least one set of contact pads (22,23) per die pad (21), and
- a support lead (25) connected to the sets of contact pads (22,23) assigned to adjacent die pads (21),
- an area (AR) of reduced thickness (T2) in each contact pad (22,23) of the sets extending across a full width (W22) of the respective contact pad (22,23),
- mounting semiconductor chips (3) on the die pads (21),
- arranging the leadframe (2) in the mold (4) the one or more protrusions (411) of the mold (4) reaching into the areas (AR) of reduced thickness (T2),
- applying a mold compound into the mold (4) for generating an arrangement comprising at least a partial encapsulation (1) of the semiconductor chips (3) with the areas (AR) of reduced thickness (T2) remaining free from the mold compound by means of the protrusions (411) in the mold (4),
- separating individual semiconductor packages from the arrangement in the area (AR) of reduced thickness (T2) of each contact pad (22) of the respective set (22,23).

12. Method according to claim 11,
wherein the sets of contact pads (22, 23) assigned to adjacent die pads (21) connect to the support lead (25) from opposite sides, and
wherein each area (AR) of reduced thickness (T2) of a contact pad (22, 23) extends into the support lead (25) where the areas (AR) of reduced thickness (T2) of opposite contact pads (22) of the sets join.

13. Method according to claim 12,
wherein the support lead (25) is of reduced thickness (T2) at least between the two outmost contact pads (22, 23) of each sets terminating in the support lead (25) resulting in a continuous area of reduced thickness (T2) across the support lead (25) and each of the contact pads (22) of the sets (22, 23), and
preferably wherein a single protrusion (411) of the mold (4) reaches into the continuous area of reduced thickness (T2), and
preferably wherein the single protrusion (411) extends over the continuous area of reduced thickness (T2).

14. Semiconductor package, comprising
- a semiconductor chip (3) arranged on a die pad (21),
- a set of contact pads (22, 23) for electrically contacting the semiconductor package, each contact pad (22, 23) of the set comprising an area (AR) of reduced thickness (T2) extending across a full width (W22) of the corresponding contact pad (22),
- an encapsulation (1) at least partially enclosing the semiconductor chip (3),
wherein each area (AR) of reduced thickness (T2) is exposed.

15. Semiconductor package of claim 14,
wherein the semiconductor chip (3) comprises a sensing element,
wherein the encapsulation (1) comprises an access opening (11) for providing access to the sensing element, and
wherein each contact pad (22, 23) of the set is plated in the area (AR) of reduced thickness (T2).
